# EUROPEAN PATENT APPLICATION

(11) **EP 4 593 065 A1**
(43) Date of publication of application: **30.07.2025**
(21) Application number: 24221605.9
(22) Date of filing: 19.12.2024
(51) Int. Cl.: H01L 21/48, H01L 23/498, H05K 3/46

(54) **METHOD OF MANUFACTURING SUBSTRATE INCLUDING PACKAGING SUBSTRATE**

(30) Priority: 27.12.2023 KR 20230192812
(71) Applicant: Absolics Inc., Covington, GA 30014 (US)
(72) Inventor: LEE, Jong Hyun, 18469 Hwaseong-si, Gyeonggi-do (KR)
(74) Representative: BCKIP Part mbB

(57) **Abstract**

Disclosed is a method of manufacturing a substrate including a packaging substrate. The method includes an operation of preparing a glass core having core vias, a 1-1^{st} operation of forming a first metal layer on the glass core, a 1-2^{nd} operation of laminating a first insulative material layer on the first metal layer, a 1-3^{rd} operation of curing the first insulative material layer to prepare a first insulating layer, a 2-1^{st} operation of forming a second metal layer on the first insulative material layer so as to be electrically connected to the first metal layer, and a 2-2^{nd} operation of laminating a second insulative material layer on the second metal layer. The 1-3^{rd} operation includes pre-curing the first insulative material layer at a temperature of 80 °C or higher but lower than 175 °C and post-curing the first insulative material layer at a temperature of 175 °C to 230 °C.

## Description

### BACKGROUND OF THE INVENTION

### Field of the Invention

Embodiments relate to a method of manufacturing a substrate including a semiconductor packaging substrate, and more particularly to a method of manufacturing a substrate in which a packaging substrate including a glass core and an insulating layer is disposed and to a method of manufacturing the packaging substrate.

### Description of the Related Art

In the manufacture of electronic components, a process of implementing a circuit on a semiconductor wafer is referred to as a "front-end process" (abbreviated to FE process), and a process of assembling a wafer so that the same is ready to be used in actual products is referred to as a "back-end process" (abbreviated to BE process). The BE process includes a packaging process.

In recent years, electronic products have developed rapidly due to the following four core technologies in the semiconductor industry: semiconductor technology, semiconductor packaging technology, manufacturing process technology, and software technology. Semiconductor technology has developed in various forms, such as implementation of a micro-to nano-scale line width, 10 million or more cells, high-speed operation, and massive heat dissipation. However, packaging technology has not been sufficiently established. Thus, in some cases, the electrical performance of a semiconductor depends on packaging technology and electrical connection implemented thereby, rather than semiconductor technology.

Ceramic or resin is used as the material of a packaging substrate. However, research on application of silicon or glass to high-end packaging substrates has recently been conducted. Particularly, a packaging substrate having a cavity structure by applying a glass core thereto has been developed.

The most widely used packaging substrate, for example, flip chip-ball grid array (FC-BGA), employs an Ajinomoto Build-up Film (ABF) that serves as an insulator and an adhesive.

Meanwhile, a re-distribution layer (RDL) in the packaging process is a general term for technology that changes the position of the already-formed electrical terminal to an arbitrary position. This RDL is used as a method to resolve design restrictions in semiconductor manufacturing plants through packaging, that is, is utilized for stacking of semiconductor chips.

As related art documents, there are Korean Patent Application Publication No. 10-2022-0135442, Korean Patent Application Publication No. 10-2013-0090115, and Chinese Patent Application Publication No. CN 115334784.

### SUMMARY OF THE INVENTION

An aspect of the embodiments is directed to providing a method of manufacturing a packaging substrate in which alignment between alignment marks and the positional stability thereof are improved when formed on a build-up layer.

Another aspect of the embodiments is directed to providing a method of manufacturing a packaging substrate capable of minimizing or preventing the influence of shrinkage of an insulative material.

In order to accomplish the above aspects, a method of manufacturing a substrate including a packaging substrate according to an embodiment includes a preparation operation of preparing a glass core as a glass plate having a plurality of core vias, a 1-1^{st} operation of forming a first metal layer on the glass core, a 1-2^{nd} operation of laminating a first insulative material layer on the first metal layer, a 1-3^{rd} operation of curing the first insulative material layer to prepare a first insulating layer, a 2-1^{st} operation of forming a second metal layer on the first insulative material layer so as to be electrically connected to the first metal layer, and a 2-2^{nd} operation of laminating a second insulative material layer on the second metal layer.

The 1-3^{rd} operation may include a pre-curing process of pre-curing the first insulative material layer at a pre-curing temperature of about 80 °C or higher but lower than about 175 °C and a post-curing process of post-curing the first insulative material layer at a post-curing temperature of about 175 °C to about 230 °C.

Accordingly, a substrate divided into a product area in which a plurality of products, each of which is the packaging substrate, is disposed and a dummy area other than the product area may be manufactured.

The pre-curing process may be performed by sequentially implementing a first step and a second step.

The first step may be heat treatment performed for 10 minutes or longer at a temperature of about 110 °C or higher but lower than about 150 °C.

The second step may be heat treatment performed for 10 minutes or longer at a temperature of about 150 °C or higher but lower than about 175 °C.

The method may further include a 2-3^{rd} operation after the 2-2^{nd} operation.

The 2-3^{rd} operation may be an operation of curing the second insulative material layer to prepare a second insulating layer.

The first metal layer and the first insulating layer may be included in a first re-distribution layer, and the second metal layer and the second insulating layer may be included in a second re-distribution layer.

The first re-distribution layer located in the dummy area may contain a first alignment mark, and the second re-distribution layer located in the dummy area may contain a second alignment mark.

In the substrate, a distance between the position of the first alignment mark and the position of the second alignment mark may have a difference of about 5 µm or less from a predetermined distance.

The first alignment mark may be a part of the first metal layer.

The second alignment mark may be a part of the second metal layer.

When a distance between the first alignment mark and the second alignment mark in the 2-1^{st} operation is D1 and when a distance between the first alignment mark and the second alignment mark in the 2-3^{rd} operation is D2, a difference between D1 and D2 may be about 5 µm or less.

The 2-3^{rd} operation may include a pre-curing process of pre-curing the second insulative material layer at a temperature of about 80 °C or higher but lower than about 175 °C and a post-curing process of post-curing the second insulative material layer at a temperature of about 175 °C to about 230 °C.

The method may further include a 3-1^{st} operation, a 3-2^{nd} operation, and a 3-3^{rd} operation after the 2-2^{nd} operation.

The 3-1^{st} operation may be an operation of forming a third metal layer on the second insulative material layer so as to be electrically connected to the second metal layer.

The 3-2^{nd} operation may be an operation of laminating a third insulative material layer on the third metal layer.

The 3-3^{rd} operation may be an operation of curing the third insulative material layer to prepare a third insulating layer.

The degree of heat shrinkage of the first insulating layer may be less than the degree of heat shrinkage of the first insulative material layer.

A method of manufacturing a packaging substrate according to another embodiment includes an operation of preparing a substrate manufactured by the method described above and a singulation operation of separating a product disposed in the product area from the substrate.

### BRIEF DESCRIPTION OF THE DRAWINGS

The above and other objects, features and other advantages of the present disclosure will be more clearly understood from the following detailed description taken in conjunction with the accompanying drawings, in which:
FIG. 1 is a conceptual view showing the cross-sectional structure of a packaging substrate according to an embodiment;
FIG. 2 is a conceptual view showing the cross-sectional structure of a packaging substrate according to another embodiment;
(a) and (b) of FIG. 3 are conceptual views showing the cross-sections of parts of the packaging substrates according to the respective embodiments;
FIG. 4 is a cross-sectional view showing a process of forming a core layer during the packaging substrate manufacturing process according to an embodiment through (a) to (e), wherein PR represents pre-curing and PT represents post-curing;
FIG. 5 is a cross-sectional view showing a process of forming a first re-distribution layer during the packaging substrate manufacturing process according to an embodiment through (a) to (e), wherein PR represents pre-curing and PT represents post-curing;
FIG. 6 is a cross-sectional view showing a process of forming a second re-distribution layer during the packaging substrate manufacturing process according to an embodiment through (a) to (e), wherein PR represents pre-curing and PT represents post-curing; and
FIG. 7 is a view for explaining an alignment mark of a packaging substrate according to an embodiment.

### DETAILED DESCRIPTION OF THE INVENTION

Hereinafter, embodiments of the present disclosure will be described in detail with reference to the accompanying drawings so that those skilled in the art can easily carry out the embodiments. The present disclosure may, however, be embodied in many different forms, and should not be construed as being limited to the embodiments set forth herein. Like reference numerals designate like elements throughout the specification.

Throughout the present specification, the phrase "combination(s) thereof included in a Markush-type expression denotes one or more mixtures or combinations selected from the group consisting of components stated in the Markush-type expression, that is, denotes that one or more components selected from the group consisting of the components are included.

Throughout the present specification, terms such as "first," "second," "A," or "B" are used to distinguish the same terms from each other. The singular forms "a," "an," and "the" include the plural form unless the context clearly dictates otherwise.

Throughout the present specification, the term "X-based" may mean that a compound includes a compound corresponding to X or a derivative of X.

Throughout the present specification, "B being disposed on A" means that B is disposed in direct contact with A or disposed above A with another layer interposed therebetween, and thus should not be interpreted as being limited to B being disposed in contact with a surface of A.

Throughout the present specification, "B being connected to A" means that B is directly connected to A or is connected to A through another element therebetween, and thus should not be interpreted as being limited to B being directly connected to A, unless noted otherwise.

Throughout the present specification, a singular form is contextually interpreted as including a plural form as well as a singular form unless specially stated otherwise.

In the process of developing a semiconductor device capable of exhibiting high performance with a more integrated structure and a thinner thickness, the inventors have recognized that not only the device itself but also the packaging process is an important factor for improvement of performance of the device. During research thereon, the inventors have confirmed that it is possible to make a packaging substrate thinner and to improve the electrical properties of the semiconductor device through methods such as application of a glass core in a single layer and application of a cavity structure, unlike a conventional interposer and organic substrate in which two or more layers of cores are applied to a motherboard as a packaging substrate.

The process of forming a re-distribution layer (RDL) involves a process of forming an insulating layer such as an Ajinomoto Build-up Film (ABF). The insulating layer may be formed through a fluidization process of moving an insulative material to the surface of a glass core and the interior of a hole such as a core via, a pre-curing process of preliminarily curing the fluidized insulative material, rather than completely curing the same, and a post-curing process of completely curing the insulative material. However, the inventors have found that the positional alignment between the metal pattern and the via was reduced during the above processes, and have recognized the need for improvement.

As a result of repeated research, the inventors have confirmed that it is possible to increase the resistance of the insulating layer to shrinkage curing by subdividing the operation of curing the insulative material for layer build-up and repeatedly exposing the insulating layer to heat, and propose the following embodiments.

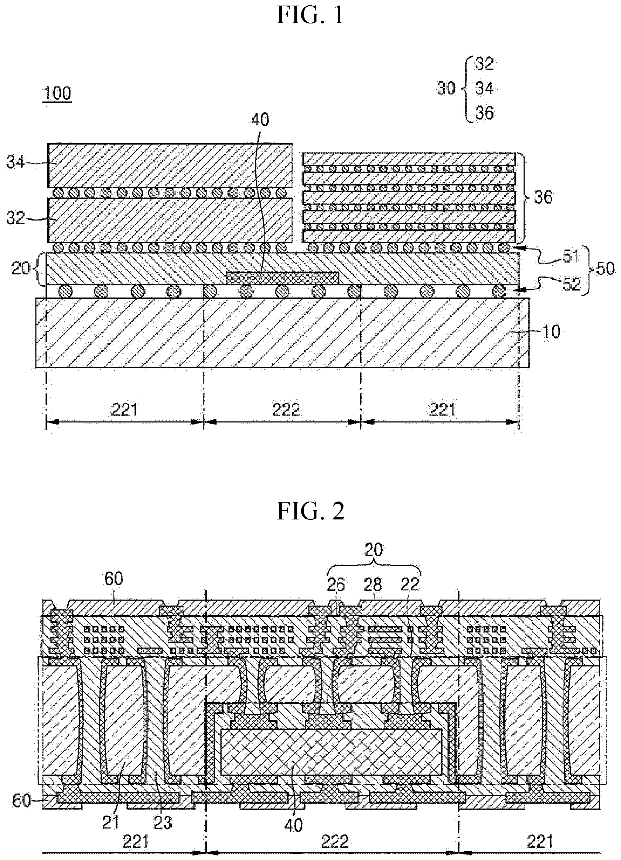

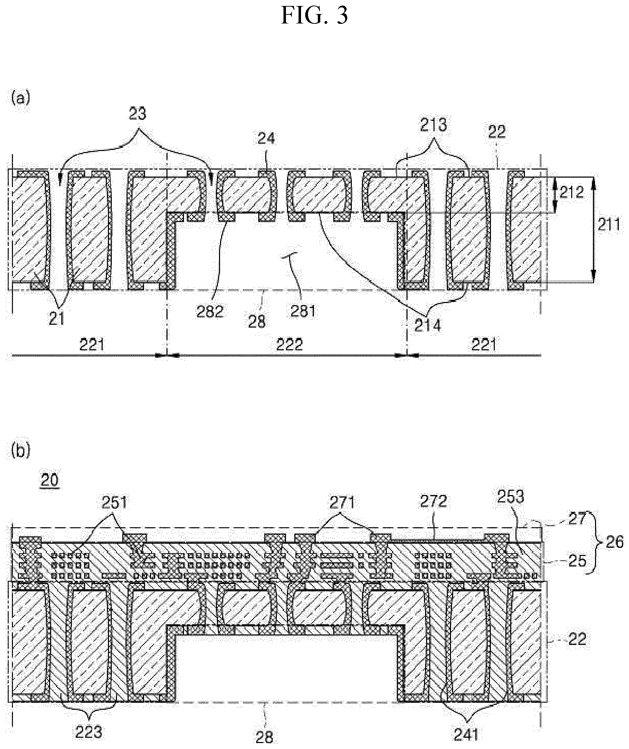

FIG. 1 is a conceptual view showing the cross-sectional structure of a packaging substrate according to an embodiment, FIG. 2 is a conceptual view showing the cross-sectional structure of a packaging substrate according to another embodiment, and (a) and (b) of FIG. 3 are conceptual views showing the cross-sections of parts of the packaging substrates according to the respective embodiments.

In order to accomplish the above aspects, a semiconductor device 100 according to the embodiment comprises a semiconductor element unit 30 in which one or more semiconductor elements 32, 34, and 36 are disposed, a packaging substrate 20 electrically connected to the semiconductor elements, and a motherboard 10 electrically connected to the packaging substrate 20 and configured to transmit external electrical signals to the semiconductor elements 32, 34, and 36 and to interconnect the semiconductor elements.

The packaging substrate 20 according to an embodiment comprises a core layer 22, an upper layer 26 disposed on one surface of the core layer 22, and a cavity portion 28 formed to allow an electric element 40 to be disposed therein.

The semiconductor element unit 30 refers to elements mounted on the semiconductor device, and is mounted on the packaging substrate 20 through a connection electrode or the like. In detail, for example, a computation element (a first element 32 and a second element 34) such as a central processing unit (CPU) or a graphics processing unit (GPU) and a memory element (a third element 36) such as a memory chip may be employed as the semiconductor element unit 30. However, any semiconductor element may be employed without limitation, so long as the same is capable of being mounted on the semiconductor device.

A motherboard such as a printed circuit board or a printed wiring board may be employed as the motherboard 10.

Optionally, the packaging substrate 20 may further comprise a lower layer (not shown) disposed under the core layer.

The core layer 22 may comprise a glass core 21 comprising a first area 221 having a first thickness 211 and a second area 222 neighboring the first area 221 and having a second thickness 212 smaller than the first thickness, a plurality of core vias 23 formed through the glass core 21 in a thickness direction, and a core distribution layer 24 disposed on a surface of the glass core 21 or the core via 23 to electrically connect a first surface 213 of the glass core 21 to a second surface 214 of the glass core 21 formed opposite the first surface 213 through the core via 23. That is, the core layer 22 may refer to a glass structure comprising, in addition to the glass core 21 comprising the first surface 213 and the second surface 214 opposite each other, the core via 23 or the cavity portion 28, or both the core via 23 and the cavity portion 28.

The second area 222 of the core layer 22 may serve as a cavity structure.

Within the same area, the glass core 21 has a first surface 213 and a second surface 214, which are opposite each other, and the two surfaces 213 and 214 are substantially parallel to each other, so that the glass core 21 has a constant overall thickness.

An inner space 281 defined due to a difference in thickness between the first area 221 and the second area 222 serves to accommodate a portion or the entirety of the electric element 40.

The glass core 21 may comprise core vias 23 penetrating the first surface 213 and the second surface 214. The core vias 23 may be formed both in the first area 221 and the second area 222, and may be formed with an intended pitch and pattern.

Conventionally, a silicon substrate and an organic substrate are employed in a stacked form as a packaging substrate of a semiconductor device. In the case of a silicon substrate, when the same is applied to a high-speed circuit, there is a concern of a parasitic element occurring due to semi conductivity thereof, and power loss is relatively large. In the case of an organic substrate, increase in area thereof is required in order to form a more complicated distribution pattern thereon. However, this does not match the trend of electronic devices being miniaturized. In order to form a complicated distribution pattern within a given area, it is substantially necessary to make the pattern finer. However, there is actual limitation in making the pattern finer due to the characteristics of a material (e.g., polymer) applied to the organic substrate.

As a solution to the above problems, the embodiment uses the glass core 21 as a support structure for the core layer 22. In addition to the glass core 21, due to the core via 23 formed through the glass core 21, it is possible to provide a packaging substrate 20 having properties of shortened electrical flow path, smaller size, faster response, and lower loss.

It is preferable that plate glass applied to a semiconductor be employed as the glass core 21. For example, borosilicate plate glass, non-alkali plate glass, or the like may be employed. However, the embodiments are not limited thereto.

The core via 23 penetrates the glass core 21. The core via 23 may be formed in a manner of removing a predetermined region of the glass core 21. In detail, the core via 23 may be formed by etching plate glass in a physical and/or chemical manner.

In detail, the core via 23 may be formed in a manner of forming a defect (recess) on the surface of the glass core using a laser or the like and then chemically etching the glass core, or may be formed in a laser etching manner. However, the embodiments are not limited thereto.

The number of core vias 23 disposed within a unit area (1 cm × 1 cm) of the glass core 21 may be 100 to 3000, may be 100 to 2500, or may be 225 to 1024. When this pitch condition is satisfied, formation of an electrically conductive layer may be possible and the performance of the packaging substrate may be improved.

The core distribution layer 24 comprises a core distribution pattern 241, which is an electrically conductive layer electrically interconnecting the first and second surfaces of the glass core through the core via, and a core insulating layer 223 surrounding the core distribution pattern 241. In the core layer 22, the electrically conductive layer is formed through the core via, and thus serves as an electrical passage crossing the glass core 21, thereby interconnecting the upper and lower sides of the glass core with a relatively short distance. Accordingly, the core layer 22 may have properties of faster electrical signal transmission and lower loss. For example, a copper plated layer may be employed as the electrically conductive layer. However, the embodiments are not limited thereto.

The cavity portion 28 may be formed in a substantially circular, triangular, quadrangular, hexagonal, octagonal, or cross shape. However, the embodiments are not limited to any specific shape of the cavity portion 28.

The electric element 40 may be formed in a substantially cylindrical, rectangular parallelepiped, or polyhedral shape.

The cavity portion 28 may comprise a cavity distribution pattern, which is an electrically conductive layer electrically connecting the electric element 40 to the core distribution layer 24, and an insulating layer surrounding the cavity distribution pattern.

On the other hand, a cavity portion according to another embodiment may be implemented in a form of penetrating the first surface 213 and the second surface 214 of the glass core 21. In this case, the cavity portion may be formed through the same process as the process of forming the core via 23. However, the area and shape of the cavity portion penetrating the glass core 21 may be different from those of the core via 23.

In this embodiment, after the electric element 40 is placed in the cavity portion, an insulating layer may be formed. That is, an insulating layer may also be formed in the cavity portion through the process in which the above-described core insulating layer 223 is formed.

The core distribution pattern 241 may comprise a pattern formed so as to be electrically connected to the electric element 40.

The electric element 40 may comprise an active element such as a transistor or a power transmission element such as a multilayer ceramic capacitor (MLCC), i.e., a passive element.

When the electric element 40 is implemented as an element such as a transistor, which serves to convert an electrical signal between the motherboard and the semiconductor element unit into a signal having an adequate level, a configuration in which the transistor is located in a path of the packaging substrate 20 may be created. In this case, it is possible to provide a semiconductor device 100 having higher operational efficiency and speed.

In addition, a power transmission element such as a multilayer ceramic capacitor (MLCC) plays an important role in the performance of the semiconductor element. In general, at least 200 power transmission elements, as passive elements, are applied to the semiconductor element. The power transmission performance of the power transmission element is also affected by the properties of the electrically conductive layer provided around the power transmission element. In one embodiment, a core via having a non-circular shape, rather than a circular shape, may be applied to a part requiring a low-resistance electrically conductive layer, such as the power transmission element.

Meanwhile, passive elements such as capacitors may be individually inserted into the electric element 40. Alternatively, an element group comprising multiple passive elements embedded between insulator layers (cavity insulating layers) may be formed such that the electrode thereof is exposed, and may then be inserted into the electric element. In the latter case, packaging substrate manufacturing efficiency may be improved, and the insulating layer may be more sufficiently and highly reliably placed in a space between complicated elements.

The glass core 21 plays an intermediate role or an intermediary role that connects the semiconductor element unit 30 and the motherboard 10 to the upper side and the lower side thereof, respectively, and the core via 23 serves as an electrical signal transmission passage between the semiconductor element unit 30 and the motherboard 10, thereby ensuring smooth signal transmission. The core via disposed in the first area 221 will be referred to as a first-area core via 231 so as to be distinguished from the core via disposed in the second area 222, which will be described later.

The upper layer 26 is disposed on the first surface 213.

The upper layer 26 may comprise an upper distribution layer 25 and an upper surface connection layer 27 disposed on the upper distribution layer 25. The uppermost surface of the upper layer 26 may be protected by a cover layer 60 having formed therein an opening, with which a connection electrode of the semiconductor element unit is in direct contact.

The upper distribution layer 25 comprises an upper insulating layer 253 disposed on the first surface and an upper distribution pattern 251 embedded in the upper insulating layer 253. The upper distribution pattern 251 is an electrically conductive layer having a predetermined pattern, at least a portion of which is electrically connected to the core distribution layer 24. Upper distribution layers 25 disposed in a vertical direction may be connected to each other through a blind via 252.

Any material may be used for the upper insulating layer 253, so long as the upper insulating layer 253 is capable of being applied to the semiconductor element or the packaging substrate as an insulator layer. For example, an epoxy-based resin containing a filler may be used for the upper insulating layer 253. However, the embodiments are not limited thereto.

The insulator layer may be formed in a manner of forming and curing a coating layer, or may be formed in a manner of laminating an insulator film in a non-cured or semi-cured state onto the core layer 22 and then curing the insulator film. In this case, if a reduced-pressure lamination method is used, the insulator may also enter the space in the core via 23, and thus the process may be efficiently performed.

According to one embodiment, even if multiple insulator layers are formed in a stacked type, it may be difficult to make a practical distinction between the insulator layers, and the multiple insulator layers will be collectively referred to as an upper insulating layer. In addition, the same insulative material may be used for the core insulating layer 223 and the upper insulating layer 253, and in this case, the boundary therebetween may not be substantially distinguished. Alternatively, according to another embodiment, the pressures and temperatures at which the multiple insulator layers are cured may be set to be different from each other, thereby creating a boundary between the insulator layers.

The upper distribution pattern 251 refers to an electrically conductive layer disposed in the upper insulating layer 253 in a preset form. For example, the upper distribution pattern 251 may be formed in a build-up layer manner. In detail, the upper distribution pattern 251 may be formed by repeatedly performing processes of: forming an insulator layer, removing an unnecessary portion of the insulator layer, forming an electrically conductive layer through copper plating or the like, removing an unnecessary portion of the electrically conductive layer, forming another insulator layer on the electrically conductive layer, removing an unnecessary portion of the other insulator layer, and forming another electrically conductive layer through copper plating or the like. In this way, it is possible to form the upper distribution pattern 251 in which the electrically conductive layer is formed in a desired pattern in the vertical or horizontal direction.

Because the upper distribution pattern 251 is disposed between the core layer 22 and the semiconductor element unit 30, the upper distribution pattern 251 may be formed such that a fine pattern is comprised in at least a portion thereof in order to ensure smooth electrical signal transmission with the semiconductor element unit 30 and to sufficiently accommodate a desired complicated pattern. In this case, the fine pattern may be a pattern having a width and an interval, each of which is less than 4 µm, 3.5 µm or less, 3 µm or less, 2.5 µm or less, or 2.3 µm or less. Alternatively, the interval may be 1 µm or more (hereinafter, the description of the fine pattern is the same).

The upper surface connection layer 27 comprises an upper surface connection pattern 272, at least a portion of which is electrically connected to the upper distribution pattern 251 and which is disposed on the upper insulating layer 253, and an upper surface connection electrode 271, which electrically connects the semiconductor element unit 30 to the upper surface connection pattern 272. The upper surface connection pattern 272 may be disposed on one surface of the upper insulating layer 253, or may be embedded in the upper insulating layer 253 with at least a portion thereof exposed above the upper insulating layer 253. For example, when the upper surface connection pattern is located on one surface of the upper insulating layer, the upper insulating layer may be formed through plating or the like, and when the upper surface connection pattern is embedded in the upper insulating layer with a portion thereof exposed above the upper insulating layer, a copper plated layer may be formed, and then a portion of the insulating layer or the electrically conductive layer may be removed through surface polishing, surface etching, or the like.

At least a portion of the upper surface connection pattern 272 may comprise a fine pattern, like the upper distribution pattern 251 described above. The upper surface connection pattern 272 comprising the fine pattern may enable a larger number of elements to be electrically connected to one another even in a narrow area, thereby ensuring smoother electrical signal connection between the elements or with an external device and realizing more integrated packaging.

The upper surface connection electrode 271 may be directly connected to the semiconductor element unit 30 through a terminal or the like, or may be connected to the semiconductor element unit 30 via an element connection part 51 such as a solder ball.

The cavity portion 28 comprises a cavity distribution layer 282 disposed at an upper portion and/or a lower portion in the second area 222 and electrically connected to the core distribution pattern 241 and an inner space 281 in which the electric element 40 is disposed. The cavity distribution layer 282 may be formed through the second-area core via 232.

In detail, the thickness of the glass core 21 in the second area 222 is smaller than in the first area 221, and the electric element 40 may be disposed in the inner space 281 defined due to a difference in the thickness. In addition, the core via 23 and the core distribution layer 24 formed in the glass core 21 serve as a structure for electrically connecting the electric element 40 to an external device.

In addition, as described above, the cavity portion penetrating the first surface 213 and the second surface 214 of the glass core 21 may be formed in the first area 221, rather than the second area 222, and the electric element 40 may be disposed in the cavity portion.

The packaging substrate 20 is also connected to the motherboard 10. The motherboard 10 may be directly connected to the core direction pattern 241, which is disposed on at least a portion of the second surface 214 of the core layer 22, through a terminal of the motherboard 10, or may be electrically connected to the core distribution pattern 241 via a board connection part 52 such as a solder ball. In addition, the core distribution pattern 241 in contact with the motherboard 10 may be connected to the motherboard 10 via a lower layer (not shown) disposed under the core layer 22. The element connection part 51 and the board connection part 52 will be collectively referred to as a connection part 50.

In one example, a substantially separate substrate other than the glass core 21 may not be applied to the packaging substrate 20 disposed between the semiconductor element unit 30 and the motherboard 10.

Conventionally, an interposer and an organic substrate are applied in a stacked structure to a connection portion between the element and the motherboard. Such a multistage form is employed for at least two reasons. One reason is that there is a scale mismatch when directly bonding a fine pattern of the element to the motherboard. The other reason is that wiring lines may be damaged due to a difference in the coefficient of thermal expansion during the bonding process or the process of driving the semiconductor device. The embodiment solves the above problems by applying a glass core having a similar coefficient of thermal expansion to that of the semiconductor element and forming a fine pattern having a fine enough scale to mount the element on the first surface of the glass core and the upper layer thereof.

Hereinafter, a method of manufacturing a substrate in which a packaging substrate is disposed according to an embodiment of the present disclosure will be described.

The substrate manufacturing method according to the embodiment comprises a preparation operation of preparing a glass core, which is a glass plate having a plurality of core vias, a 1-1^{st} operation of forming a first metal layer on the glass core, a 1-2^{nd} operation of laminating a first insulative material layer on the first metal layer, a 1-3^{rd} operation of curing the first insulative material layer to form a first insulating layer, a 2-1^{st} operation of forming a second metal layer on the first insulative material layer so as to be electrically connected to the first metal layer, a 2-2^{nd} operation of laminating a second insulative material layer on the second metal layer, and a 2-3^{rd} operation of curing the second insulative material layer to form a second insulating layer.

The 1-3^{rd} operation may comprise a pre-curing process of pre-curing the first insulative material layer at a temperature of about 80 °C or higher but lower than about 175 °C and a post-curing process of post-curing the first insulative material layer at a temperature of about 175 °C to about 230 °C.

Through the above-described operations, it is possible to manufacture a substrate that is divided into a product area in which a plurality of products, which are the packaging substrates, is disposed and a dummy area other than the product area.

The process of manufacturing the substrate will be described below in more detail.

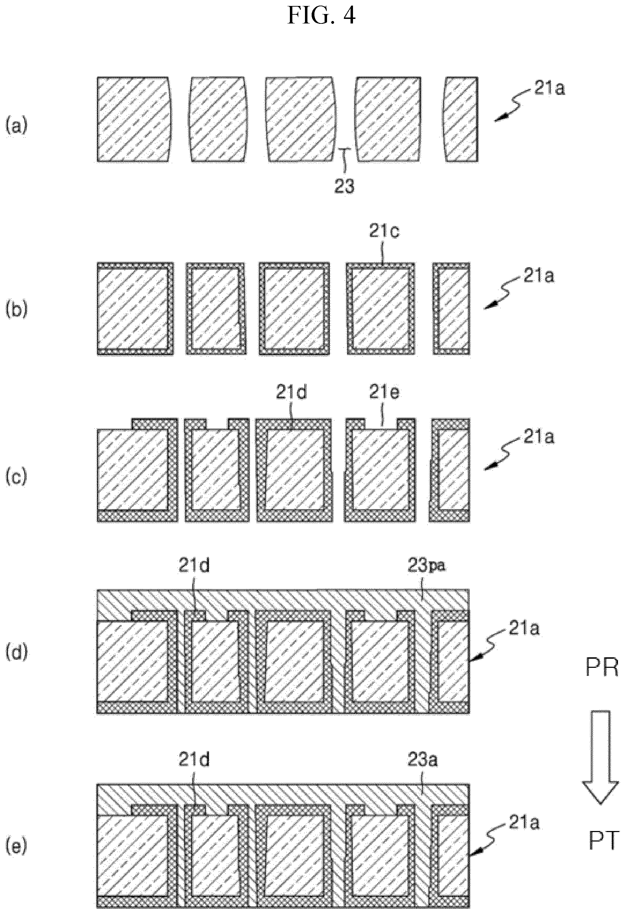

FIGs. 4 to 6 are cross-sectional views showing the process of manufacturing a substrate on which a packaging substrate is disposed according to an embodiment.

FIG. 4 is a cross-sectional view showing a process of forming a core layer during the substrate manufacturing process according to an embodiment.

As shown in (a) of FIG. 4, a glass core 21a having a core via 23 is provided (preparation operation). The core via 23 may be formed by performing physical or chemical etching on the glass core 21a. This etching process is referred to as an etching operation.

Before the chemical etching, a defect (recess) (not shown) may be formed at a predetermined position in the surface of glass in order to form the core via in the glass core 21a having flat first and second surfaces. A glass core applied to a substrate of an electronic device or the like may be employed as the glass. For example, a non-alkali glass core may be employed. However, the embodiments are not limited thereto. As commercially available products, products manufactured by manufacturers such as Corning Inc., Schott AG, and AGC Inc. may be used. In order to form the defect (recess), mechanical etching, laser radiation, or the like may be used.

During the etching process, the via may be formed in the defect portion of the glass core, and at the same time, the surface of the glass core 21a may also be etched. A masking film or the like may be used in order to prevent the surface of the glass from being etched. However, the glass core itself having the defect may be etched in consideration of any inconvenience caused by the process of applying and removing the masking film. In this case, the glass core having the core via may be slightly thinner than the original glass core.

Thereafter, an electrically conductive layer may be formed so as to surround the core via 23 and the first and second surfaces of the glass core 21a. As a representative example of the electrically conductive layer, a metal layer containing copper may be employed. However, the embodiments are not limited thereto.

Thereafter, an operation of forming a metal layer (metal layer forming operation) may be performed. For example, a case in which this operation is performed on the glass core may referred to as a 1-1^{st} operation, a case in which this operation is performed on a first re-distribution layer may be referred to as a 2-1^{st} operation, and a case in which this operation is performed on a second re-distribution layer may be referred to as a 3-1^{st} operation.

The metal layer forming operation may comprise a process of forming an electrically conductive layer (metal layer) after formation of a seed layer/primer layer. In order to form the electrically conductive layer (metal layer) in a predetermined pattern and shape, the metal layer forming operation may further comprise a process of removing a portion of the seed layer/primer layer or the electrically conductive layer.

In detail, as shown in (b) of FIG. 4, a seed layer 21c may be formed on the surface of the glass core 21a and the inner diameter portion of the core via 23.

The surface of glass (comprising the surface of the glass core and the surface of the core via) and the surface of copper have different properties and thus are less adhesive. In the embodiment, the adhesive strength between the glass surface and the metal may be increased through two methods, i.e., a dry method and a wet method.

The dry method is a method applying sputtering, that is, a method of forming a seed layer 21c on the glass surface and the inner diameter portion of the core via through metal sputtering. During formation of the seed layer, a heterogeneous metal such as titanium, chromium, or nickel may be sputtered together with copper. In this case, glass-metal adhesion may be improved by the anchor effect, in which the surface morphology of the glass and the metal particles interact with each other.

The wet method is a method applying primer treatment, that is, a method of forming a primer layer (not shown) by performing pre-treatment with a compound having a functional group such as an amine functional group. Depending on the desired degree of adhesive strength, after pre-treatment with a silane coupling agent, the primer treatment may be performed with a compound or particle having an amine functional group. As described above, it is desirable for the supporting substrate of the embodiment to have a high performance enough to form a fine pattern, and the high performance should be maintained even after the primer treatment. Accordingly, when such a primer contains nanoparticles, it is preferable that nanoparticles having an average diameter of 150 nm or less be applied. For example, it is preferable that nanoparticles be employed as particles having amine functional groups. The primer layer may be formed by applying, for example, a CZ-series adhesive strength improving agent manufactured by MEC Inc.

In the seed layer/primer layer, an electrically conductive layer, i.e., a metal layer, may be selectively formed with or without removing a portion on which the formation of the electrically conductive layer is undesirable. Also, in the seed layer/primer layer, a subsequent process may be performed after a portion on which the formation of the electrically conductive layer is desirable or a portion on which the formation of the electrically conductive layer is undesirable is selectively processed such that the portion is activated or deactivated for metal plating. For example, light radiation treatment using laser light of a certain wavelength, chemical treatment, or the like may be applied to the activation or deactivation process. A copper plating method or the like applied to manufacture of the semiconductor element may be applied to formation of the metal layer. However, the embodiments are not limited thereto.

The seed layer 21c is a layer for improving adhesion between the glass core 21a and the electrically conductive layer 21d, and may comprise a metal commonly used in the art as a material that is highly adhesive to copper. For example, during formation of the seed layer 21c, a heterogeneous metal such as chromium (Cr), titanium (Ti), silver (Ag), copper (Cu), nickel (Ni), nichrome, or palladium (Pd) may be sputtered together with copper. In this case, glass-metal adhesion may be improved by the anchor effect, in which the surface morphology of the glass core 21a and the metal particles interact with each other.

When a copper metal layer is formed in the plating process, the seed layer 21c functions as a seed that allows copper to be effectively plated. In one example, the metal that functions as a seed is preferably one metal selected from the group consisting of copper (Cu), silver (Ag), and nickel (Ni). Preferably, copper (Cu) is used. This case is advantageous in terms of formation of a metal electrode through a plating or etching process (wet process) compared to a case of using other metals such as silver (Ag). Particularly, copper plating is performed on copper formed on the seed layer 21c, the thickness of the copper wire may be increased more easily than when other metallic materials are used, and accordingly the resistance of the copper wire may be easily lowered.

According to one example, titanium and copper may be sequentially sputtered on the seed layer 21c, and may be laminated to a thickness range of about 200 µm to about 400 µm.

Forming the seed layer 21c in order to improve adhesion between the glass core 21a and the electrically conductive layer 21d corresponds to a dry method. According to another example, a wet method, which is a primer treatment method performing pretreatment with a compound, may also be employed.

Referring to (c) of FIG. 4, an electrically conductive layer 21d may be formed on the glass core 21a based on the seed layer 21c. In the seed layer 21c, a metal layer, which is an electrically conductive layer, may be formed with or without removing a portion on which the formation of the electrically conductive layer 21d is undesirable. This metal layer may be a first metal layer.

The electrically conductive layer 21d may be formed with an unnecessary portion of the seed layer 21c removed. Alternatively, after the electrically conductive layer 21d is formed, a portion thereof may be removed according to a predetermined pattern (refer to 21e).

In order to perform the removal, a photoresist layer may be formed on the seed layer 21c or the electrically conductive layer 21d.

The photoresist layer may be formed by applying a photoresist solution to the seed layer 21c or may be formed by laminating a dry film photoresist (DFR) on the seed layer 21c. Various other conventional techniques may be used, so long as a photoresist capable of forming a circuit pattern through photosensitization is used. A positive-type or negative-type photoresist may be used depending on the design. Thereafter, the dry film photoresist may be exposed to ultraviolet (UV) light and developed.

For example, a portion of the dry film photoresist under a UV-blocking portion thereof remains unexposed. In the area in which UV light is radiated, the dry film photoresist is exposed to UV light. Then, the exposed portion of the dry film photoresist is developed, and the unexposed portion of the photoresist layer is removed.

After the development, the portion of the dry film photoresist that is present under the UV-blocking portion thereof and thus is not exposed to UV light is washed away by means of water, and only the portion of the dry film photoresist exposed to UV light remains.

Metal such as copper may be plated on the portion from which the dry film photoresist has been removed to form the metal layer.

The seed layer 21c may be exposed through the portion from which the unexposed portion of the dry film photoresist has been removed. Due to the characteristics of metal plating, if the exposed portion of the seed layer 21c is plated with the same metal as the seed layer 21c, thick metal wiring may be formed much more easily than in a case of growing a metal layer through sputtering. In addition, because the metal of the seed layer 21c and the metal of the electrically conductive layer 21d are identical to each other, the seed layer 21c after plating and the electrically conductive layer 21d may form an integrated wiring.

Thereafter, the remaining portion of the dry film photoresist may be stripped.

Due to the stripping of the dry film photoresist, the seed layer 21c made of a metal material is exposed to an etching solution, and a portion of the seed layer 21c on which the metal layer is not formed is etched and removed. Any type of etching solution may be used, so long as the same is a stripping solution capable of stripping the photoresist.

Through the above-described operations, when the seed layer 21c present in the area in which the metal layer is not formed is removed, the electrically conductive layer 21d allowing flow of current therethrough may be finally formed on the glass core 21a.

As shown in (c) of FIG. 4, when a portion of the core distribution layer is unnecessary, the portion may be removed. An etching layer 21e of the core distribution layer may be formed by forming an electrically conductive layer in a predetermined pattern through metal plating after partially removing or deactivating the seed layer.

The operation of forming an insulative material layer is an operation of placing an insulative material layer on the electrically conductive layer (metal layer) (insulative material layer forming operation). For example, an operation of laminating a first insulative material layer on the first metal layer may be referred to as a 1-2^{nd} operation, an operation of laminating a second insulative material layer on the second metal layer may be referred to as a 2-2^{nd} operation, and an operation of laminating a third insulative material layer on the third metal layer may be referred to as a 3-2^{nd} operation.

The operation of forming an insulating layer is an operation of curing the insulative material layer to form an insulating layer (curing operation). For example, a operation of curing the first insulative material layer to form a first insulating layer may be referred to as a 1-3^{rd} operation, an operation of curing the second insulative material layer to form a second insulating layer may be referred to as a 2-3^{rd} operation, and an operation of curing the third insulative material layer to form a third insulating layer may be referred to as a 3-3^{rd} operation.

In detail, an insulative material layer 23pa may be formed.

The core via may undergo the insulative material layer forming operation of filling the empty space with an insulative material after the formation of the core distribution layer, which is the electrically conductive layer 21d. In this case, the insulative material layer may be formed as a core insulating layer or an insulating layer 23a through a method of coating a resin composition or laminating an insulating film. For simplicity, it is desirable to perform a method of laminating an insulating film. Lamination of the insulating film may be performed by a process of laminating and curing the insulating film. In this case, if a reduced-pressure lamination method is applied, an insulative material may be sufficiently embedded even into an inner portion of the core via in which the electrically conductive layer is not formed. Through this reduced-pressure lamination, the insulative material may be sufficiently embedded into the empty space in the core via, thereby obtaining a core insulating layer having substantially no voids. It is desirable that the insulative material have characteristics allowing the glass core and the insulating layer (having completely undergone curing) to satisfy an adhesion test value of 4B or more according to ASTM D3359.

The operation of curing the insulative material may comprise a pre-curing process of preliminarily curing the insulative material fluidized and placed at a predetermined position, rather than completely curing the insulative material, and a full-curing or post-curing process of completely curing the insulative material.

In detail, an insulative material in the form of a film or the like is laminated on the first surface and/or the second surface of the glass core 21a. Then, the reduced-pressure lamination method is performed so that adhesion to the glass core 21a is increased, and the insulative material is disposed so that voids are not substantially formed in the core. Thereafter, the pre-curing may be performed through a thermal curing method. In this case, the pre-curing means that the insulating film is cured to an intermediate level, rather than being completely cured, and may be controlled by regulating the curing temperature.

For example, the curing operation may comprise a pre-curing process of pre-curing the insulative material layer at a pre-curing temperature of about 80 °C or higher but lower than about 175 °C and a post-curing process of post-curing the insulative material layer at a post-curing temperature of about 175 °C to about 230 °C.

For example, the pre-curing temperature may be about 80 °C or higher, about 90 °C or higher, about 100 °C or higher, about 110 °C or higher, or about 120 °C or higher. The pre-curing temperature may be lower than about 175 °C or may be about 170 °C or lower.

For example, the heat treatment time in the pre-curing process may be about 20 minutes or more, about 30 minutes or more, about 40 minutes or more, or about 50 minutes or more. The heat treatment time may be about 150 minutes or less, about 130 minutes or less, about 110 minutes or less, about 90 minutes or less, about 80 minutes or less, or about 70 minutes or less.

For example, the post-curing temperature may be about 175 °C or higher, about 180 °C or higher, about 185 °C or higher, or about 190 °C or higher. The post-curing temperature may be about 230 °C or lower, about 220 °C or lower, about 210 °C or lower, or about 205 °C or lower.

For example, the heat treatment time in the post-curing process may be about 30 minutes or more, about 40 minutes or more, about 50 minutes or more, or about 60 minutes or more. The heat treatment time may be about 130 minutes or less, about 120 minutes or less, about 100 minutes or less, or about 90 minutes or less.

Referring to (d) and (e) of FIG. 4, the insulating layer 23a may be formed through the pre-curing process of forming the insulative material layer 23pa on the first surface and then pre-curing the same and the post-curing process of completely curing the insulative material layer to obtain the insulating layer.

In the case of an insulating layer composed of multiple layers, an insulative material for forming a single layer is disposed to form an insulative material layer, and then pre-curing is performed thereon. After this process is repeated multiple times, in the final operation, all the insulative material layers undergo post-curing so as to be completely cured. In this case, each insulating layer having undergone only pre-curing may have low heat resistance because curing shrinkage is not sufficiently achieved. Accordingly, the insulative material layer filling the core via may shrink during the curing process, and alignment between the layers (e.g., alignment between the metal layers) may be reduced.

According to the embodiment, in order to resolve the instability of the insulating layer, post-curing for forming each insulating layer may be performed multiple times. Through this process, the insulating layer may be repeatedly exposed to heat during layer build-up, and thus the resistance thereof to shrinkage-curing may be increased.

In this case, the temperature in the post-curing operation may be higher than the temperature in the pre-curing operation, and the curing time in the post-curing operation may be longer than the curing time in the pre-curing operation. The pre-curing temperature and time and the post-curing temperature and time have been described above. However, the temperature and time may be varied depending on the insulative material that is used.

A difference between the pre-curing temperature and the post-curing temperature may be about 30 °C or higher, about 35 °C or higher, or about 40 °C or higher. This case may be more helpful in improving alignment between the layers.

The pre-curing process may be performed by sequentially implementing a first step and a second step.

The first step may be heat treatment that is performed for about 10 minutes or longer at a temperature of about 110 °C or higher but lower than about 150 °C, and the second step may be heat treatment that is performed for about 10 minutes or longer at a temperature of about 150 °C or higher but lower than about 175 °C.

In detail, the temperature of the first step may be about 110 °C or higher, about 115 °C or higher, about 120 °C or higher, or about 125 °C or higher. The temperature of the first step may be lower than about 150 °C, about 145 °C or lower, about 140 °C or lower, or about 135 °C or lower. The heat treatment time in the first step may be about 10 minutes or more, about 15 minutes or more, or about 20 minutes or more. The heat treatment time may be about 50 minutes or less, about 45 minutes or less, about 40 minutes or less, or about 35 minutes or less.

In detail, the temperature of the second step may be about 150 °C or higher, about 155 °C or higher, or about 160 °C or higher. The temperature of the second step may be lower than about 175 °C, about 170 °C or lower, or about 165 °C or lower. The heat treatment time in the second step may be about 10 minutes or more, about 15 minutes or more, or about 20 minutes or more. The heat treatment time may be about 50 minutes or less, about 45 minutes or less, about 40 minutes or less, or about 35 minutes or less.

The manufacturing method of the packaging substrate described with reference to FIG. 4 may be summarized as follows. A first metal layer such as an electrically conductive layer surrounding the core via 23 and the first and second surfaces of the glass core 21a may be formed, and an insulating layer may be formed on the first metal layer. The insulating layer may be formed through a pre-curing operation of laminating an insulating film on the first surface and then pre-curing the same and a post-curing operation of completely curing the insulating film.

According to the above-described embodiment, when the insulating layer 23a is formed on the upper surface or the lower surface of the glass core 21a, a metal distribution pattern having a multilayer structure and an insulator layer may be formed on the insulating layer 23a. That is, an upper layer 26 shown in FIGs. 2 and 3 may be formed on the insulating layer 23a, and a lower layer (not shown) may also be formed on a lower insulating layer (not shown).

A second metal layer electrically connected to the first metal layer may be formed on the insulating layer.

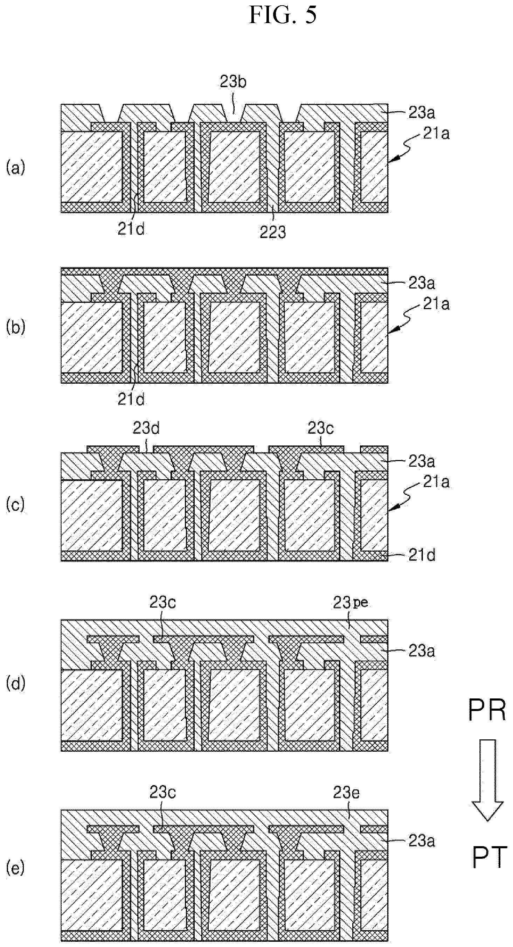

FIG. 5 is a cross-sectional view showing a process of forming a second re-distribution layer on the first re-distribution layer during the packaging substrate manufacturing process according to an embodiment.

The first re-distribution layer comprises the first metal layer and the first insulating layer, and the second re-distribution layer comprises the second metal layer and the second insulating layer.

In the embodiment, the second re-distribution layer may refer to a first layer comprised in the upper layer formed on the core layer. The second re-distribution layer may comprise the second metal layer, which is the upper distribution pattern, and the second insulating layer 23e formed on the second metal layer.

First, as shown in (a) of FIG. 5, a blind via 23b for forming the second metal layer may be formed in the first insulating layer 23a. In order to form the blind via 23b, a dry etching method, such as laser etching or plasma etching, or a wet etching method using a masking layer and an etchant may be employed.

The second metal layer may be formed by forming the blind via 23b and then performing a plating process (refer to (b) and (c) of FIG. 5).

The second metal layer may be formed by repeating a process of forming the electrically conductive layer 23c in a predetermined pattern on the first insulating layer 23a and then etching an unnecessary portion to form an etching layer 23d of the electrically conductive layer.

Thereafter, an operation of forming a second insulative material layer 23pe on the second metal layer may be performed. The second insulative material layer 23pe is formed through a process of laminating an insulative material layer on the second metal layer and then pre-curing the same (refer to (d) of FIG. 5) and a post-curing process of completely curing the insulative material layer (refer to (e) of FIG. 5).

According to the embodiment, after the first insulating layer formed in FIG. 4, i.e., the core insulating layer covering the first or second surface while filling the core via, is formed through pre-curing and post-curing, the second insulating layer 23e of the second re-distribution layer formed on the upper layer may also be formed through pre-curing and post-curing. In other words, pre-curing and post-curing are performed at each operation in which the insulating layer is formed, thereby increasing resistance to shrinkage.

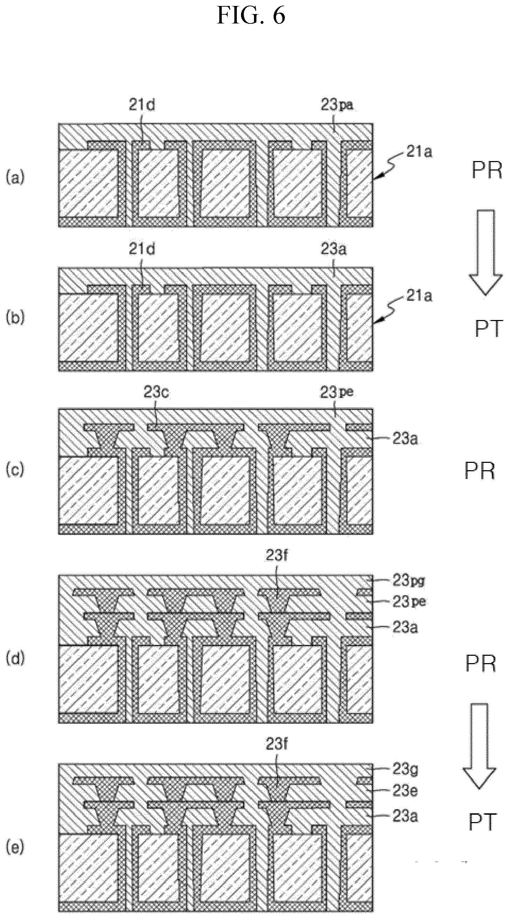

FIG. 6 is a cross-sectional view showing a process of forming a second re-distribution layer during the packaging substrate manufacturing process according to another embodiment.

According to the embodiment, the first insulating layer 23a may be cured through pre-curing and post-curing, as shown in (a) and (b) of FIG. 6, and the second insulating layer 23e may be formed in the state of the second insulative material layer 23pe only through the pre-curing operation (refer to (c) of FIG. 6).

Thereafter, a third metal layer comprised in a third re-distribution layer may be formed on the second insulative material layer 23pe. The third metal layer may comprise an electrically conductive layer 23f and a portion to be etched, like the second metal layer. A third insulative material layer 23pg may be formed on the third metal layer.

According to the embodiment, the third insulative material layer 23pg is formed through a process of laminating an insulative material such as an insulating film on the third metal layer and then pre-curing the same (refer to (d) of FIG. 6) and a post-curing process of completely curing the laminated insulative material layer (refer to (e) of FIG. 6).

In summary, the packaging substrate according to the embodiment may comprise a second insulative material layer 23pe formed on the second metal layer, a third metal layer formed on the second insulative material layer 23pe and electrically connected to the second metal layer, and a third insulative material layer 23pg formed on the third metal layer. The second insulative material layer 23pe may be formed through an operation of laminating an insulative material on the second metal layer and then pre-curing the same, and the third insulative material layer 23pg may be formed through an operation of laminating an insulative material on the third metal layer and then pre-curing the same and a post-curing operation of completely curing the insulating film.

According to another embodiment, the second insulating layer 23e may also be formed by implementing the pre-curing and post-curing operations.

In other words, in a packaging substrate in which a plurality of layers is formed and an insulating layer is comprised in each of the layers, the insulating layer may be formed through pre-curing and post-curing whenever each layer is formed, or may be formed through pre-curing and post-curing at intervals at which two or three layers are formed. For example, if an insulating layer comprised in the first re-distribution layer is formed through pre-curing and post-curing, only pre-curing may be performed on insulating layers comprised in the subsequent second re-distribution layer and third layer, and an insulating layer comprised in the subsequent fourth layer may be formed through pre-curing and post-curing.

Thereafter, although not shown, an upper surface connection layer and a cover layer may be formed.

An upper surface connection pattern and an upper surface connection electrode may also be formed through a process similar to the process of forming the upper distribution layer. In detail, the upper surface connection pattern and the upper surface connection electrode may be formed through a process of forming an etching layer of an insulating layer on the upper insulating layer, forming an electrically conductive layer thereon, and then forming an etching layer of the electrically conductive layer. However, a method of selectively forming only an electrically conductive layer without implementing etching may be employed. The cover layer may have an opening (not shown) formed therein at a position corresponding to the upper surface connection electrode so as to expose the upper surface connection electrode, and may be formed so as to be directly connected to a terminal connection portion or a terminal of an element.

If the upper layer is formed, a process of forming a lower surface connection layer and a cover layer to form a lower layer may be performed. A lower distribution layer and/or a lower surface connection layer and a cover layer (optional) (not shown) may be formed through a process similar to the above-described process of forming the upper surface connection layer and the cover layer.

If the upper layer or the lower layer is finally formed, a completely curing operation of completely curing the insulating films of the core insulating layer and the insulator layer having a multilayer structure may be additionally performed.

A process of planarizing the surface of the substrate may be performed between the pre-curing process and the post-curing process described above. That is, it is possible to induce the upper surface of the insulating layer to be planarized. For example, a method of placing a film for planarization (e.g., PET film) on the insulating layer during the reduced-pressure lamination process may be employed. However, the planarization method is not limited thereto.

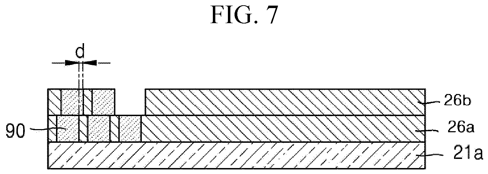

FIG. 7 is a view for explaining an alignment mark of a packaging substrate according to an embodiment.

In the process of manufacturing the packaging substrate, when layers are formed, an alignment mark is formed in each of the layers of the packaging substrate in order to align metal layers formed in the respective layers.

The substrate may comprise a predetermined dummy area.

The substrate may be divided into a product area in which a plurality of products, which are the packaging substrates, is disposed and a dummy area other than the product area. The alignment mark may be formed outside the product area or may be formed within the packaging substrate (e.g., a peripheral portion of the packaging substrate).

According to an example, the alignment mark may be generated in the operation of forming the first metal layer and the operation of forming the second metal layer in the above-described embodiment, that is, when forming the metal layer of each layer.

FIG. 7 shows a first re-distribution layer 26a and a second re-distribution layer 26b formed on the glass core 21a and shows an alignment mark 90 formed in each of the layers.

The alignment mark is an index based on which alignment between wirings of the respective layers, the degree of shift between the layers, and the wiring accuracy are measured and examined. A smaller positional deviation d between the alignment marks of the respective layers means that there is no shift between the layers and the wiring accuracy is higher.

Although the alignment marks are illustrated in FIG. 7 as being disposed vertically, the alignment mark of the first re-distribution layer 26a and the alignment mark of the second re-distribution layer 26b are not necessarily disposed vertically, and it is sufficient if the alignment marks are disposed at predetermined positions. However, during the process of forming the insulating layer, shrinkage of the material may occur, and thus the alignment marks may be disposed at positions different from the predetermined positions. The embodiment minimizes these problems.

In detail, the first re-distribution layer 26a comprises the first metal layer and the first insulating layer, and the second re-distribution layer 26b comprises the second metal layer and the second insulating layer. In addition, a first alignment mark is disposed in the first re-distribution layer in the dummy area, and a second alignment mark is disposed in the second re-distribution layer in the dummy area.

The first alignment mark may be a part of the first metal layer.

The second alignment mark may be a part of the second metal layer.

In the substrate, a distance between the position of the first alignment mark and the position of the second alignment mark may have a difference of about 5 µm or less from a predetermined distance. The difference may be about 5 µm or less, about 4 µm or less, about 3.5 µm or less, or about 3 µm or less. The difference may be about 0.1 µm or greater, about 1 µm or greater, or about 2 µm or greater.

For example, the first re-distribution layer 26a comprises the first metal layer and the first insulating layer, and the second re-distribution layer 26b comprises the second metal layer and the second insulating layer. In addition, the first alignment mark is disposed in the first re-distribution layer in the dummy area, and the second alignment mark is disposed in the second re-distribution layer in the dummy area.

When a distance between the first alignment mark and the second alignment mark in the 2-1^{st} operation is D1 and when a distance between the first alignment mark and the second alignment mark in the 2-3^{rd} operation is D2, a difference between D1 and D2 may be about 5 µm or less. The difference may be about 5 µm or less, about 4 µm or less, about 3.5 µm or less, or about 3 µm or less. The difference may be about 0.1 µm or greater, about 1 µm or greater, or about 2 µm or greater. According to the embodiment, during the heat treatment, the degree of heat shrinkage of the first insulating layer may be less than the degree of heat shrinkage of the first insulative material layer.

A method of manufacturing a packaging substrate according to another embodiment comprises a process of singulating the product portion from the substrate manufactured by the substrate manufacturing method described above. The packaging substrate manufactured in this way has a high degree of fine alignment, thereby enabling implementation of a thin line-space and implementation of a more integrated packaging substrate.

According to the method of manufacturing a substrate comprising a packaging substrate and the packaging substrate using the same according to the embodiments described above, the insulating layer is repeatedly exposed to heat during layer build-up, whereby resistance of the insulating layer to shrinkage curing may be increased, and movement of a silica filler and a filling agent may be minimized or prevented. Accordingly, it is possible to minimize the occurrence of operations and bending of the surface of the insulating layer caused by the mobility of the filler when the insulating layer is pre-cured. That is, according to the packaging substrate manufacturing method according to the embodiment, it is possible to minimize the fluidity of the RDL and to improve alignment between the alignment marks formed in the build-up layers and the positional stability thereof.

As is apparent from the above description, according to the method of manufacturing a packaging substrate of the embodiment, because an insulative material is repeatedly exposed to heat during layer build-up, resistance of an insulating layer to shrinkage curing may be increased.

According to the method of manufacturing a packaging substrate of the embodiment, the occurrence of shrinkage of an insulative material during a heat treatment process may be minimized or prevented. Accordingly, it is possible to reduce the occurrence of operations and bending of the surface of the insulating layer caused by shrinkage of the insulative material when the insulative material is pre-cured.

According to the method of manufacturing a packaging substrate of the embodiment, it is possible to improve alignment between wirings represented by alignment marks formed in build-up layers and the positional stability of the wirings.

The embodiment may minimize deformation of the pre-cured insulative material, thereby increasing the alignment accuracy of patterns and vias between layers and increasing the positional stability of the patterns and the vias.

Although preferred embodiments of the present disclosure have been illustrated and described in order to exemplify the principle of the present disclosure, the present disclosure is not limited to the specific embodiments. It will be understood that various modifications and changes can be made by those skilled in the art without departing from the spirit and scope of the disclosure as defined by the appended claims. Accordingly, the true technical scope of the present disclosure should be defined by the technical spirit of the appended claims.

## Claims

1. A method of manufacturing a substrate comprising a packaging substrate, the method comprising:
a preparation operation of preparing a glass core as a glass plate having a plurality of core vias;
a 1-1^{st} operation of forming a first metal layer on the glass core;
a 1-2^{nd} operation of laminating a first insulative material layer on the first metal layer;
a 1-3^{rd} operation of curing the first insulative material layer to prepare a first insulating layer;
a 2-1^{st} operation of forming a second metal layer on the first insulative material layer so as to be electrically connected to the first metal layer; and
a 2-2^{nd} operation of laminating a second insulative material layer on the second metal layer,
wherein the 1-3^{rd} operation comprises:
a pre-curing process of pre-curing the first insulative material layer at a pre-curing temperature of about 80 °C or higher but lower than about 175 °C; and
a post-curing process of post-curing the first insulative material layer at a post-curing temperature of about 175 °C to about 230 °C,
whereby a substrate divided into a product area in which a plurality of products, each being the packaging substrate, is disposed and a dummy area other than the product area is manufactured.

2. The method according to claim 1, wherein the pre-curing process is performed by sequentially implementing a first step and a second step,
wherein the first step is heat treatment performed for about 10 minutes or longer at a temperature of about 110 °C or higher but lower than about 150 °C, and
wherein the second step is heat treatment performed for about 10 minutes or longer at a temperature of about 150 °C or higher but lower than about 175 °C.

3. The method according to claim 1 or claim 2, further comprising a 2-3^{rd} operation after the 2-2^{nd} operation,
wherein the 2-3^{rd} operation is an operation of curing the second insulative material layer to prepare a second insulating layer.

4. The method according to claim 3,
wherein the first metal layer and the first insulating layer are comprised in a first re-distribution layer,
wherein the second metal layer and the second insulating layer are comprised in a second re-distribution layer,
wherein the first re-distribution layer located in the dummy area contains a first alignment mark,
wherein the second re-distribution layer located in the dummy area contains a second alignment mark, and
wherein, in the substrate, a distance between a position of the first alignment mark and a position of the second alignment mark has a difference of about 5 µm or less from a predetermined distance.

5. The method according to claim 4,
wherein the first alignment mark is a part of the first metal layer, and
wherein the second alignment mark is a part of the second metal layer.

6. The method according to any one from claim 3 to claim 5,
wherein the first metal layer and the first insulating layer are comprised in a first re-distribution layer,
wherein the second metal layer and the second insulating layer are comprised in a second re-distribution layer,
wherein the first re-distribution layer located in the dummy area contains a first alignment mark,
wherein the second re-distribution layer located in the dummy area contains a second alignment mark,
wherein a distance between the first alignment mark and the second alignment mark in the 2-1^{st} operation is D1,
wherein a distance between the first alignment mark and the second alignment mark in the 2-3^{rd} operation is D2, and
wherein a difference between D1 and D2 is about 5 µm or less.

7. The method according to any one from claim 3 to claim 6, wherein the 2-3^{rd} operation comprises:
a pre-curing process of pre-curing the second insulative material layer at a temperature of about 80 °C or higher but lower than about 175 °C; and
a post-curing process of post-curing the second insulative material layer at a temperature of about 175 °C to about 230 °C.

8. The method according to any one from claim 2 to claim 7, further comprising a 3-1^{st} operation, a 3-2^{nd} operation, and a 3-3^{rd} operation after the 2-2^{nd} operation,
wherein the 3-1^{st} operation is an operation of forming a third metal layer on the second insulative material layer so as to be electrically connected to the second metal layer,
wherein the 3-2^{nd} operation is an operation of laminating a third insulative material layer on the third metal layer, and
wherein the 3-3^{rd} operation is an operation of curing the third insulative material layer to prepare a third insulating layer.

9. The method according to any one from claim 2 to claim 8, wherein a degree of heat shrinkage of the first insulating layer is less than a degree of heat shrinkage of the first insulative material layer.

10. A method of manufacturing a packaging substrate, the method comprising:
an operation of preparing a substrate manufactured by the method of claim 1; and
a singulation operation of separating a product disposed in the product area from the substrate.
